# EUROPEAN PATENT APPLICATION

(11) **EP 4 203 658 A1**
(43) Date of publication of application: **28.06.2023**
(21) Application number: 22215137.5
(22) Date of filing: 20.12.2022
(51) Int. Cl.: H10K 59/40, H10K 59/80

(54) **DISPLAY APPARATUS AND METHOD OF MANUFACTURING THE DISPLAY APPARATUS**

(30) Priority: 22.12.2021 KR 20210185413
(71) Applicant: Samsung Display Co., Ltd., Yongin-si, Gyeonggi-do 17113 (KR)
(72) Inventor: KWON, Ohjune, Yongin-si 17113 (KR); LEE, Jeongseok, Yongin-si 17113 (KR)
(74) Representative: Marks & Clerk LLP

(57) **Abstract**

A display apparatus which is in-folded or out-folded in a folded area thereof includes a substrate, a plurality of display elements disposed over the substrate, an encapsulation layer sealing the plurality of display elements, and a reinforcement part disposed on the encapsulation layer and arranged in the folded area.

## Description

### BACKGROUND

### 1. Field

One or more embodiments relate to a display apparatus, and more particularly, to a display apparatus in which a crack occurrence is suppressed.

### 2. Description of the Related Art

Electronic apparatuses such as smartphones, digital cameras, notebook computers, navigation apparatuses, smart televisions, and the like may include a display apparatus for displaying images. The display apparatus generates images and displays images to a user through a display screen.

Recently, the purpose of using display apparatuses has been diversified, and various types of display apparatuses have been developed along with technology developments. Such display apparatuses may include flexible display apparatuses that are easy to carry and may improve user convenience.

### SUMMARY

Among flexible display apparatuses, a foldable display apparatus may be foldable or folded with respect to a folding axis. However, when a foldable display apparatus is folded, damage to various elements may occur in a folded area transformed in a curved shape from a flat state.

One or more embodiments include a display apparatus that may suppress crack occurrence.

According to one or more embodiments, a display apparatus which is in-folded or out-folded in a folded area thereof includes a substrate, a plurality of display elements disposed over the substrate, an encapsulation layer sealing the plurality of display elements, and a reinforcement part disposed on the encapsulation layer and arranged in the folded area.

In an embodiment, the display apparatus may be in-folded or out-folded in a same folded area, and a thickness of the reinforcement part may vary in the folded area.

In an embodiment, the reinforcement part may include a protrusion portion disposed on two opposite sides of a folding axis around the folding axis in the folded area.

In an embodiment, the protrusion portion may include a plane portion having a constant thickness and an inclined surface portion having a thickness decreasing as being away from the plane portion from two opposite sides of the plane portion.

In an embodiment, the protrusion portion may be arranged to be symmetric with respect to the folding axis.

In an embodiment, a thickness of the reinforcement part overlapping the folding axis may be less than a thickness of the protrusion portion.

In an embodiment, the reinforcement part may include a transparent material.

In an embodiment, the display apparatus may further include a display area and a peripheral area surrounding the display area, where a portion of the reinforcement part in the display area and a portion of the reinforcement part the peripheral area may include different materials from each other.

In an embodiment, the display apparatus may further include a display area and a peripheral area surrounding the display area, where the reinforcement part may be arranged in the peripheral area.

In an embodiment, the display apparatus may further include a touch sensor layer disposed on the reinforcement part.

In an embodiment, the folded area may include a first folded area which is out-folded, and a second folded area which is in-folded, where the reinforcement part may include a first reinforcement part arranged in the first folded area.

In an embodiment, the display apparatus may further include a touch sensor layer disposed between the first reinforcement part and the encapsulation layer.

In an embodiment, the reinforcement part may further include a second reinforcement part disposed on the encapsulation layer and arranged in the second folded area.

In an embodiment, the first reinforcement part and the second reinforcement part may be connected to each other and integrally formed with each other as a single unitary and indivisible body.

In an embodiment, a thickness of the first reinforcement part may be greater than a thickness of the second reinforcement part.

In an embodiment, the first reinforcement part and the second reinforcement part may include different materials from each other.

In an embodiment, the display apparatus may further include a backside reinforcement part disposed on a backside of the substrate in the second folded area.

According to one or more embodiments, a display apparatus including a display surface which is bent (*e.g.* bendable) in a partial region thereof and displays images and a non-display surface opposite to the display surface, includes a substrate, and a reinforcement part disposed on the display surface in the partial region of the substrate, where the reinforcement part alleviates a tensile force applied to the substrate.

In an embodiment, the reinforcement part may be disposed between an encapsulation layer and a touch sensor layer, the encapsulation layer may be disposed over the substrate, and the touch sensor layer may be disposed on the encapsulation layer.

In an embodiment, the display apparatus may further include a display area and a peripheral area surrounding the display area, where the reinforcement part may be arranged in the peripheral area.

In an embodiment, a thickness of the reinforcement part may vary.

According to one or more embodiments, a method of manufacturing a display apparatus which is in-folded or out-folded in a folded area thereof includes providing an encapsulation layer over a substrate on which a plurality of display elements is disposed, and coating a reinforcement part on the encapsulation layer in the folded area.

In an embodiment, the coating the reinforcement part may include coating the reinforcement part in a way such that a thickness of the reinforcement part varies in the folded area.

In an embodiment, the coating of the reinforcement part may include coating the reinforcement part only in a periphery of the substrate in which the plurality of display elements is not arranged.

In an embodiment, the method may further include providing a touch sensor layer on the encapsulation layer to cover the reinforcement part.

At least some of the above and other features of the invention are set out in the claims.

### BRIEF DESCRIPTION OF THE DRAWINGS

The above and other features of certain embodiments of the disclosure will be more apparent from the following description taken in conjunction with the accompanying drawings, in which:
FIGS. 1 and 2 are perspective views of a display apparatus according to an embodiment.
FIG. 3 is a cross-sectional view of a portion of a display apparatus according to an embodiment, taken along line I-I' of FIG. 1.
FIG. 4 is a cross-sectional view of the display panel according to an embodiment, taken along line II-II' of FIG. 1;
FIG. 5 is a cross-sectional view of the display panel of FIG. 4 in an out-folded state;
FIG. 6 is a cross-sectional view of the display panel of FIG. 4 in an in-folded state;
FIG. 7 is a schematic cross-sectional view of a display apparatus according to an alternative embodiment;
FIGS. 8 and 9 are perspective views of a display apparatus according to an alternative embodiment;
FIG. 10 is a cross-sectional view of a display panel according to an alternative embodiment, taken along line X-X' of FIG. 8;
FIG. 11 is a cross-sectional view of the display panel according to an alternative embodiment, taken along line X-X' of FIG. 8;
FIG. 12 is a cross-sectional view of the display panel according to an alternative embodiment, taken along line X-X' of FIG. 8;
FIG. 13 is a cross-sectional view of the display panel according to an alternative embodiment, taken along line X-X' of FIG. 8;
FIG. 14 is a cross-sectional view of the display panel according to an alternative embodiment, taken along line X-X' of FIG. 8;
FIG. 15 is a perspective view of a display panel according to an alternative embodiment;
FIG. 16 is a perspective view of a display panel according to an alternative embodiment; and
FIGS. 17 to 19 are cross-sectional views showing a method of manufacturing a display apparatus according to an embodiment.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

As the present disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be further understood that, when a layer, region, or component is referred to as being "on" another layer, region, or component, it can be directly or indirectly on the other layer, region, or component. That is, for example, intervening layers, regions, or components may be present therebetween. In contrast, when an element is referred to as being "directly on" another element, there are no intervening elements present.

Sizes of elements in the drawings may be exaggerated or reduced for convenience of explanation. For example, since sizes and thicknesses of elements in the drawings are arbitrarily illustrated for convenience of explanation, the disclosure is not limited thereto.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the case where a certain embodiment may be implemented differently, a specific process order may be performed in the order different from the described order. As an example, two processes that are successively described may be substantially simultaneously performed or performed in the order opposite to the order described.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described in detail with reference to the accompanying drawings.

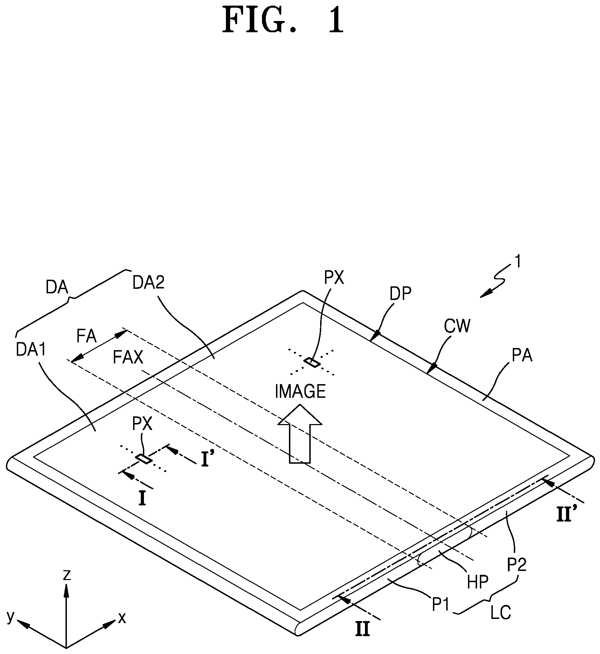

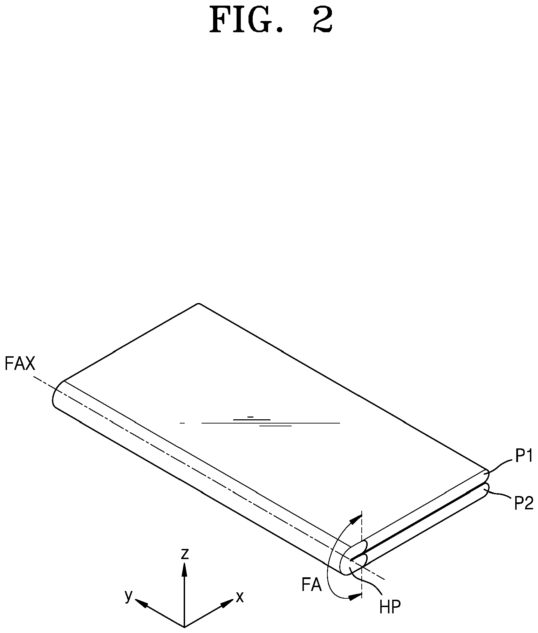

FIGS. 1 and 2 are perspective views of a display apparatus 1 according to an embodiment. Specifically, FIG. 1 shows the display apparatus 1 that is unfolded, and FIG. 2 shows the display apparatus 1 that is folded.

Referring to FIGS. 1 and 2, an embodiment of the display apparatus 1 may include a lower cover LC, a display panel DP, and a cover window CW.

The lower cover LC may form or define a lower appearance of the display apparatus 1. The lower cover LC may include plastic, metal, or both plastic and metal. The lower cover LC may include a first part P1 and a second part P2 that support the display panel DP. The lower cover LC may be folded around a folding axis FAX defined between the first part P1 and the second part P2. In an embodiment, the lower cover LC may further include a hinge part HP. The hinge part HP may be provided between the first part P1 and the second part P2.

The display panel DP may include a display area DA. The display panel DP may display images by using an array of a plurality of pixels PX arranged in the display area DA. Each pixel PX may be defined by an emission area from which light is emitted by a light-emitting element electrically connected to a pixel circuit. The light-emitting element may be, for example, an organic light-emitting diode OLED. In an embodiment, each pixel PX may emit red, green, or blue light. Alternatively, each pixel PX may emit red, green, blue, or white light.

The display area DA may include a first display area DA1 and a second display area DA2, where the first display area DA1 and the second display area DA2 are respectively arranged on two opposite sides around the folding axis FAX crossing the display area DA. The first display area DA1 and the second display area DA2 may be respectively disposed on the first part P1 and the second part P2 of the lower cover LC. The display panel DP may display a first image and a second image by using light emitted from the plurality of pixels PX arranged in the first display area DA1 and the second display area DA2. In an embodiment, the first image and the second image may be portions of one image displayed by the display area DA of the display panel DP. In an alternative embodiment, the display panel DP may display the first image and the second image which are independent images.

The display panel DP may be folded around the folding axis FAX. In an embodiment, when the display panel DP is folded, the first display area DA1 and the second display area DA2 of the display panel DP may face each other. In an alternative embodiment, when the display panel DP is folded, the first display area DA1 and the second display area DA2 of the display panel DP may face in directions opposite to each other.

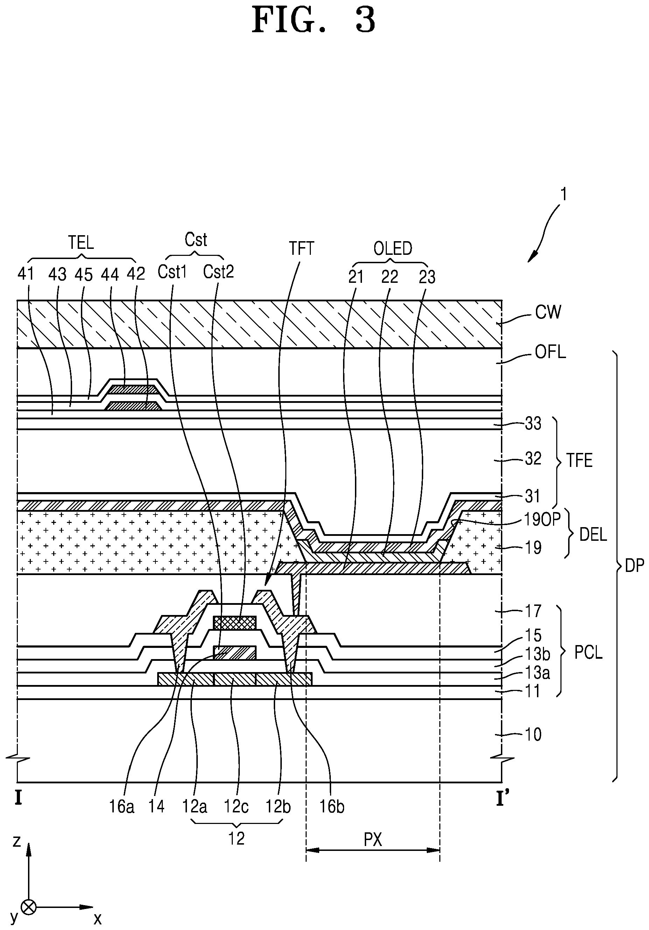

In such an embodiment, the display panel DP may be in-folded or out-folded (or foldable in an in-folding manner or foldable in an out-folding manner) with respect to the folding axis FAX. Here, in-folding may denote that the display panel DP is folded in a +z direction with respect to the folding axis FAX, and out-folding may denote that the display panel DP is folded in a -z direction with respect to the folding axis FAX. In other words, the in-folding may denote that folding is performed in a way such that the upper surfaces of the cover window CW face each other, and the out-folding may denote that folding is performed in a way such that the lower surfaces of the cover window CW face each other. In an embodiment, the lower surface of the cover window CW may denote a surface closer to a substrate 10 (see FIG. 3) in the z direction than the upper surface of the cover window CW.

The display panel DP may include a folded area FA which is a region including the folding axis FAX. The display panel DP may be in-folded and/or out-folded with respect to the folding axis FAX of the folded area FA and bent in the folded area FA.

In an embodiment, as shown in FIGS. 1 and 2, the folding axis FAX may extend in a y direction, but the embodiment is not limited thereto. In an alternative embodiment, the folding axis FAX may extend in an x direction crossing the y direction. Alternatively, the folding axis FAX may also extend in a direction crossing the x direction and the y direction.

In an embodiment, as shown in FIGS. 1 and 2, the number of the folding axes FAX provided therein may be one, but the embodiment is not limited thereto. In an alternative embodiment, the display panel DP may be folded with respect to two folding axes FAX crossing the display area DA. In an embodiment, for example, where the display panel DP is folded with respect to two folding axes FAX, the display panel DP may be in-folded with respect to one folding axis FAX, and out-folded with respect to the other folding axis FAX. Alternatively, the display panel DP may be in-folded with respect to both of the two folding axes FAX, or out-folded with respect to both of the two folding axes FAX. However, the embodiment is not limited thereto. In an embodiment, the display panel DP may be folded with respect to a plurality of folding axes FAX crossing the display area DA. In such an embodiment, the display panel DP may be in-folded with respect to each folding axis FAX, or out-folded with respect to each folding axis FAX.

The cover window CW may be disposed on the display panel DP to cover the display panel DP. The cover window CW may be folded or warped according to external force without crack occurrence. When the display panel DP is folded with respect to the folding axis FAX, the cover window CW may be folded together and may cover the display panel DP.

FIG. 3 is a cross-sectional view of a portion of the display apparatus 1 according to an embodiment. FIG. 3 may correspond to a cross-section of the display apparatus 1 taken along line I-I' of FIG. 1. That is, FIG. 3 shows a cross-section of a portion of the display apparatus 1 in the display area DA.

Referring to FIG. 3, an embodiment of the display panel DP may have a stack structure including the substrate 10, a pixel circuit layer PCL, a display element layer DEL, a thin-film encapsulation layer TFE, a touch sensor layer TEL, and an optical functional layer OFL.

The substrate 10 may include glass or a polymer resin. In this case, the polymer resin may include at least one selected from polyethersulfone, polyarylate, polyetherimide, polyethylene naphthalate, polyethylene terephthalate, polyphenylene sulfide, polyimide, polycarbonate, cellulose tri acetate, cellulose acetate propionate, and the like.

The pixel circuit layer PCL may be disposed on the substrate 10. FIG. 3 shows an embodiment where the pixel circuit layer PCL includes a thin-film transistor TFT, a buffer layer 11, a first insulating layer 13a, a second insulating layer 13b, a third insulating layer 15, and a planarization layer 17 under and/or on elements of the thin-film transistor TFT.

The buffer layer 11 may block penetration of foreign materials, moisture, or external air from below the substrate 10 and provide a flat surface on the substrate 10. The buffer layer 11 may include an inorganic insulating material such as silicon nitride, silicon oxynitride, and silicon oxide, and include a single layer or a multi-layer including the above inorganic insulating materials.

The thin-film transistor TFT on the buffer layer 11 may include a semiconductor layer 12, and the semiconductor layer 12 may include polycrystalline silicon. Alternatively, the semiconductor layer 12 may include amorphous silicon, an oxide semiconductor, or an organic semiconductor. The semiconductor layer 12 may include a channel region 12c, a drain region 12a, and a source region 12b, where the drain region 12a and the source region 12b are respectively on two opposite sides of the channel region 12c. A gate electrode 14 may overlap the channel region 12c.

The gate electrode 14 may include a low-resistance metal material. The gate electrode 14 may include a conductive material including molybdenum (Mo), aluminium (Al), copper (Cu), and titanium (Ti) and have a single-layered structure or a multi-layered structure, each layer therein including at least one selected from the above materials.

The first insulating layer 13a may be disposed between the semiconductor layer 12 and the gate electrode 14. The first insulating layer 13a may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Here, zinc oxide (ZnOₓ) may be zinc oxide (ZnO) and/or zinc peroxide (ZnO₂).

The second insulating layer 13b may cover the gate electrode 14. The second insulating layer 13b may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Here, zinc oxide (ZnOₓ) may be zinc oxide (ZnO) and/or zinc peroxide (ZnO₂).

An upper electrode Cst2 of a storage capacitor Cst may be disposed on the second insulating layer 13b. The upper electrode Cst2 may overlap at least a portion of the gate electrode 14 disposed therebelow. The gate electrode 14 and the upper electrode Cst2 overlapping each other with the second insulating layer 13b therebetween may constitute the storage capacitor Cst. In such an embodiment, the gate electrode 14 may serve as a lower electrode Cst1 of the storage capacitor Cst.

In an embodiment, as described above, the storage capacitor Cst may overlap the thin-film transistor TFT. In an alternative embodiment, the storage capacitor Cst may not overlap the thin-film transistor TFT. In such an embodiment, the lower electrode Cst1 of the storage capacitor Cst may be an element separate from the gate electrode 14 and be separated from the gate electrode 14.

The upper electrode Cst2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and have a single-layered structure or a multi-layered structure, each layer therein including at least one selected from the above materials.

The third insulating layer 15 may cover the upper electrode Cst2. The third insulating layer 15 may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Here, zinc oxide (ZnOₓ) may be zinc oxide (ZnO) and/or zinc peroxide (ZnO₂). The third insulating layer 15 may have a single-layered structure or a multi-layered structure, each layer therein including at least one selected from the inorganic insulating materials.

A drain electrode 16a and a source electrode 16b may each be disposed on the third insulating layer 15. The drain electrode 16a and the source electrode 16b may be respectively connected to the drain region 12a and the source region 12b through contact holes defined in insulating layers therebelow. The drain electrode 16a and the source electrode 16b may each include a material having a high conductivity. The drain electrode 16a and the source electrode 16b may each include a conductive material including molybdenum (Mo), aluminium (Al), copper (Cu), and titanium (Ti) and have a single-layered structure or a multi-layered structure. In an embodiment, the drain electrode 16a and the source electrode 16b may each have a multi-layered structure of Ti/AI/Ti.

The planarization layer 17 may include an organic insulating material. The planarization layer 17 may include an organic insulating material including a general-purpose polymer such as polymethylmethacrylate ("PMMA") or polystyrene ("PS"), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

The display element layer DEL may be disposed on the pixel circuit layer PCL having the above structure. The display element layer DEL may include an organic light-emitting diode OLED as a light-emitting element. The organic light-emitting diode OLED may have a stack structure of a pixel electrode 21, an emission layer 22, and a common electrode 23. The pixel electrode 21 of the organic light-emitting diode OLED may be electrically connected to the thin-film transistor TFT through a contact hole defined in the planarization layer 17.

The pixel electrode 21 may include a conductive oxide such as indium tin oxide ("ITO"), indium zinc oxide ("IZO"), zinc oxide (ZnO), indium oxide (In₂O₃), indium gallium oxide ("IGO"), or aluminium zinc oxide ("AZO"). In an embodiment, the pixel electrode 21 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. In an alternative embodiment, the pixel electrode 21 may further include a layer on/under the reflective layer, the layer including ITO, IZO, ZnOₓ, or In₂O₃.

A pixel-defining layer 19 may be disposed on the pixel electrode 21, and an opening 19OP may be defined through the pixel-defining layer 19 to expose at least a portion of the pixel electrode 21. The pixel-defining layer 19 may include an organic insulating material and/or an inorganic insulating material. The opening 19OP may define an emission area of light emitted from the organic light-emitting diode OLED. In an embodiment, for example, the size/width of the opening 19OP may correspond to the size/width of the emission area. Accordingly, the size and/or width of the pixel PX may depend on the size and/or width of the opening 19OP of the pixel-defining layer 19.

The emission layer 22 may be disposed in the opening 19OP of the pixel-defining layer 19. The emission layer 22 may include a polymer organic material or a low-molecular weight organic material that emits light of a preset color. Alternatively, the emission layer 22 may include an inorganic emission material or quantum dots.

Though not shown, a first functional layer and a second functional layer may be respectively arranged under and on the emission layer 22. The first functional layer may include, for example, a hole transport layer ("HTL"), or include an HTL and a hole injection layer ("HIL"). The second functional layer may include an electron transport layer ("ETL") and/or an electron injection layer ("EIL"). However, the embodiment is not limited thereto. The first functional layer and the second functional layer may be selectively disposed on and under the emission layer 22, respectively.

Like the common electrode 23 described below, the first functional layer and/or the second functional layer may be common layers covering the substrate 10 entirely.

The common electrode 23 may be disposed over the pixel electrode 21 and may overlap the pixel electrode 21. The common electrode 23 may include a conductive material having a low work function. In an embodiment, for example, the common electrode 23 may include a (semi) transparent layer including silver (Ag), magnesium (Mg), aluminium (Al), platinum (Pt), palladium (Pd), gold (Au), nickel (Ni), neodymium (Nd), iridium (Ir), chromium (Cr), or an alloy thereof. Alternatively, the common electrode 23 may further include a layer on the (semi) transparent layer, the layer including ITO, IZO, ZnO, or In₂O₃. The common electrode 23 may be formed as a single unitary and indivisible body to cover the substrate 10 entirely.

An encapsulation member may be disposed on the display element layer DEL. In an embodiment, the encapsulation member may be provided as or defined by the thin-film encapsulation layer TFE. The thin-film encapsulation layer TFE may be disposed on the display element layer DEL and may cover the display element layer DEL. The thin-film encapsulation layer TFE may include at least one inorganic layer and at least one organic layer. In an embodiment, the thin-film encapsulation layer TFE may include a first inorganic layer 31, an organic layer 32, and a second inorganic layer 33 that are sequentially stacked one on another. Though not shown, the encapsulation member may be provided as an encapsulation substrate.

The first inorganic layer 31 and the second inorganic layer 33 may include at least one inorganic material selected from aluminium oxide, titanium oxide, tantalum oxide, hafnium oxide, zinc oxide, silicon oxide, silicon nitride, and silicon oxynitride. The organic layer 32 may include a polymer-based material. The polymer-based material may include an acryl-based resin, an epoxy-based resin, polyimide, and polyethylene. In an embodiment, the organic layer 32 may include acrylate. The organic layer 32 may be formed by hardening a monomer or coating a polymer.

The touch sensor layer TEL may be disposed on the thin-film encapsulation layer TFE, where the touch sensor layer TFE includes touch electrodes. The touch sensor layer TEL may obtain coordinate information corresponding to an external input, for example, a touch event.

The touch sensor layer TEL may be disposed on the thin-film encapsulation layer TFE. The touch sensor layer TEL may include a first touch insulating layer 41, a first touch conductive pattern 42, a second touch insulating layer 43, a second touch conductive pattern 44, and a third touch insulating layer 45.

The first touch insulating layer 41 may be disposed on the second inorganic layer 33. In an embodiment, the first touch insulating layer 41 may be a single layer or a multi-layer including an inorganic material such as silicon nitride (SiNₓ), silicon oxide (SiO₂), and/or silicon oxynitride (SiON). In an embodiment, the first touch insulating layer 41 may include an organic material. In an alternative embodiment, the first touch insulating layer 41 may be omitted.

The first touch conductive pattern 42 may be disposed on the first touch insulating layer 41 and/or the second inorganic layer 33. In an embodiment, the first touch conductive pattern 42 may overlap the pixel-defining layer 19. The first touch conductive pattern 42 may not overlap the opening 19OP of the pixel-defining layer 19. The first touch conductive pattern 42 may include a conductive material. In an embodiment, for example, the first touch conductive pattern 42 may include at least one selected from molybdenum (Mo), aluminium (Al), copper (Cu), and titanium (Ti) and have a single-layered structure or a multi-layered structure, each layer herein including at least one selected from the above materials. In an embodiment, the first touch conductive pattern 42 may have a structure of Ti/AI/Ti in which a titanium layer, an aluminium layer, and a titanium layer are sequentially stacked.

The second touch insulating layer 43 may cover the first touch conductive pattern 42. The second touch insulating layer 43 may be a single layer or a multi-layer including an inorganic material such as silicon nitride (SiNₓ), silicon oxide (SiO₂), and/or silicon oxynitride (SiON). In an embodiment, the third touch insulating layer 45 may include an organic material.

The second touch conductive pattern 44 may be disposed on the second touch insulating layer 43. In an embodiment, the second touch conductive pattern 44 may overlap the pixel-defining layer 19. The second touch conductive pattern 44 may not overlap the opening 19OP of the pixel-defining layer 19. In an embodiment, the second touch conductive pattern 44 may be connected to the first touch conductive pattern 42 through a contact hole of the second touch insulating layer 43. The second touch conductive pattern 44 may include a conductive material. In an embodiment, for example, the second touch conductive pattern 44 may include at least one of molybdenum (Mo), aluminium (Al), copper (Cu), and titanium (Ti) and have a single-layered structure or a multi-layered structure, each layer therein including at least one selected from the above materials. In an embodiment, the second touch conductive pattern 44 may have a structure of Ti/Al/Ti in which a titanium layer, an aluminium layer, and a titanium layer are sequentially stacked one on another.

The first touch conductive pattern 42 and the second touch conductive pattern 44 may each include a plurality of sensing electrodes for sensing a touch input. In an embodiment, the first touch conductive pattern 42 and the second touch conductive pattern 44 may each include a first sensing electrode, a second sensing electrode, a first connection electrode, and/or a second connection electrode. In an embodiment, the first sensing electrode and the second sensing electrode may each sense an input by using a mutual capacitance method. In an alternative embodiment, the first sensing electrode and/or the second sensing electrode may each sense an input by using a self-capacitance method.

The third touch insulating layer 45 may cover the second touch conductive pattern 44. In an embodiment, the third touch insulating layer 45 may be a single layer or a multi-layer including an inorganic material such as silicon nitride (SiNₓ), silicon oxide (SiO₂),and/or silicon oxynitride (SiON). In an embodiment, the third touch insulating layer 45 may include an organic material.

The optical functional layer OFL may be disposed on the touch sensor layer TEL. The optical functional layer OFL may reduce the reflectivity of light (external light) incident toward the display apparatus 1 from outside, and improve the color purity of light emitted from the display apparatus 1.

In an embodiment, the optical functional layer OFL may include a retarder and/or a polarizer. The retarder may include a film-type retarder or a liquid crystal-type retarder. The retarder may include a λ/2 retarder and/or a λ/4 retarder. The polarizer may include a film-type polarizer or a liquid crystal-type polarizer. The film-type polarizer may include a stretchable synthetic resin film, and the liquid crystal-type polarizer may include liquid crystals arranged in a predetermined arrangement. Each of the retarder and the polarizer may further include a protective film.

In an embodiment, the optical functional layer OFL may include a destructive interference structure. The destructive interference structure may include a first reflection layer and a second reflection layer respectively disposed on different layers. First-reflected light and second-reflected light respectively reflected by the first reflection layer and the second reflection layer may destructively interfere and thus the reflectivity of external light may be reduced.

An adhesive member may be disposed between the touch sensor layer TEL and the optical functional layer OFL. In an embodiment, a general member known in the art may be employed as the adhesive member without limitation. In an embodiment, for example, the adhesive member may be a pressure sensitive adhesive ("PSA").

The cover window CW may be disposed on the display panel DP. The cover window CW may be adhered to the display panel DP by the adhesive member. The adhesive member may be, for example, a PSA.

The cover window CW may have a high transmittance to transmit light emitted from the display panel DP, and have a thin thickness to reduce the weight of the display apparatus 1. In addition, the cover window CW may have strength and hardness to protect the display panel DP from external impacts. The cover window CW may include, for example, glass or plastic. In an embodiment, the cover window CW may be an ultra thin reinforcement glass in which strength thereof is reinforced by methods such as chemical or thermal reinforcement.

In an embodiment, as described above, the display apparatus 1 includes an organic light-emitting diode OLED as a light-emitting element, but an embodiment of the display apparatus 1 is not limited thereto. In an alternative embodiment, the display apparatus 1 may be an inorganic light-emitting display apparatus including an inorganic light-emitting diode. The inorganic light-emitting diode may include a PN-junction diode including inorganic material semiconductor-based materials. In such an embodiment, when a forward voltage is applied to a PN-junction diode, holes and electrons are injected and energy created by recombination of the holes and the electrons is converted to light energy, and thus, light of a preset color may be emitted. The inorganic light-emitting diode may have a width in a range of several micrometers to hundreds of micrometers. In an embodiment, the inorganic light-emitting diode may be a micro light-emitting diode.

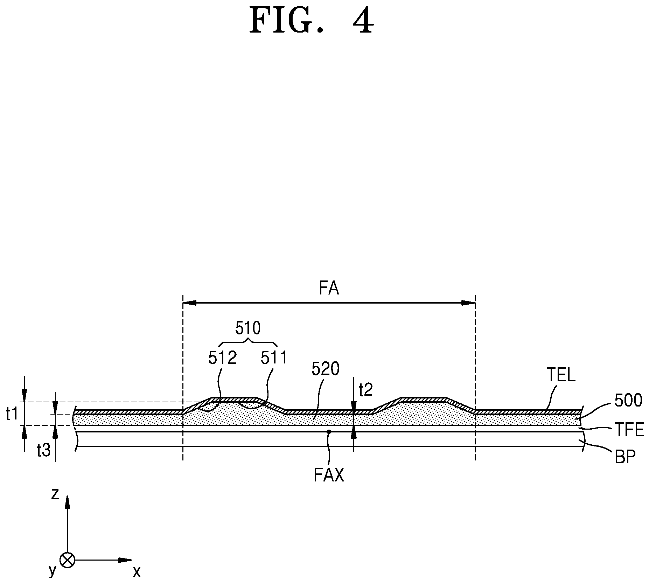

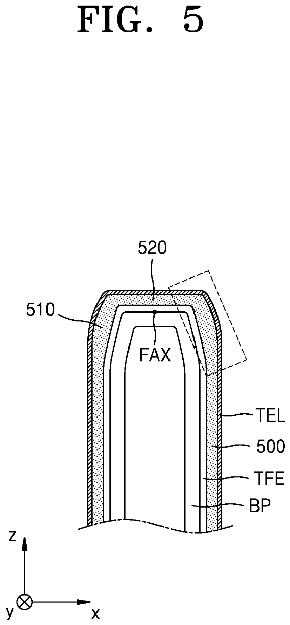

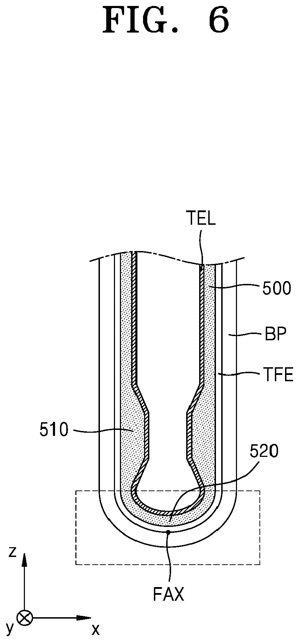

FIG. 4 is a cross-sectional view of a display panel according to an embodiment, taken along line II-II' of FIG. 1. FIG. 5 is a cross-sectional view of the display panel of FIG. 4 in an out-folded state. FIG. 6 is a cross-sectional view of the display panel of FIG. 4 in an in-folded state. For convenience of description, FIGS. 4 to 6 schematically show only the thin-film encapsulation layer TFE, layers BP under the thin-film encapsulation layer TFE, the reinforcement part 500, and the touch sensor layer TEL, and other elements are the same as and/or similar to those of FIG. 3, and thus, the other elements are not particularly illustrated.

Referring to FIG. 4, in an embodiment of a display panel, the reinforcement part 500 may be disposed on (a +z direction in FIG. 4) of the thin-film encapsulation layer TFE. The reinforcement part 500 may be disposed as or defined by a layer on the thin-film encapsulation layer TFE. The reinforcement part 500 may alleviate stress by folding in the display apparatus 1, particularly, in the folded area FA. The touch sensor layer TEL may be disposed on the reinforcement part 500.

In an embodiment, the reinforcement part 500 may be arranged in a peripheral area PA (see FIG. 1). In such an embodiment, as shown in FIG. 3 showing a cross-section in the display area DA of the display apparatus 1, the reinforcement part 500 may not be arranged in the display area DA (see FIG. 1) but may be arranged in the peripheral area PA around the display area DA as shown in FIG. 4. In an embodiment, for example, the reinforcement part 500 may be arranged on two opposite sides in the lengthwise direction (a y direction in FIG. 1) of the folding axis FAX.

In a display apparatus that is foldable, cracks may occur in the folded area due to folding. Cracks may start from the peripheral area, particularly in the folded area, and propagate to the display area. According to an embodiment, the reinforcement part 500 may be arranged in the peripheral area PA which may be a start point of the cracks as described above, and may prevent the cracks of the display apparatus 1. In such an embodiment, cracks that may occur while the display apparatus 1, particularly, the display panel DP, is folded may be prevented by using a simple method of arranging the reinforcement part 500 in the peripheral area PA without particularly changing design of the display area DA that displays images.

In an embodiment, the reinforcement part 500 may include a protrusion portion 510. The protrusion portion 510 may protrude in a direction perpendicular to a stack surface of the reinforcement part 500. In an embodiment, the protrusion portion 510 may be arranged in the folded area FA. In an embodiment, in a plan view, the protrusion portion 510 may be apart from each other on two opposite sides (a +x direction and a -x direction in FIG. 4) with respect to the folding axis FAX in the folded area FA. In such an embodiment, separation distances between the protrusion portion 510 from the folding axis FAX may be equal to each other on two opposite sides of the folding axis FAX. In such an embodiment, both protrusion portions 510 may be arranged to be symmetric with respect to the folding axis FAX.

An indented portion 520 may be disposed between the protrusion portions 510. The indented portion 520 may be formed indented by the protrusion portions on two opposite sides. The indented portion 520 may be formed as a single unitary and indivisible body with the protrusion portion.

A thickness t1 of the protrusion portion 510 may be greater than a thickness t3 of the reinforcement part 500 in a region other than the folded area FA. In an embodiment, the thickness t2 of the indented portion 520 may be equal to the thickness t3 in the region other than the folded area FA. In an alternative embodiment, the thickness t2 of the indented portion 520 may be less than the thickness t3 in the region other than the folded area FA. In another alternative embodiment, the reinforcement part 500 may not be disposed between the protrusion portions 510 on two opposite sides (that is, the thickness t2 of the indented portion 520 is 0). Hereinafter, for convenience of description, embodiments where the thickness t2 of the indented portion 520 is equal to the thickness t3 in the region other than the folded area FA will be mainly described.

In an embodiment, the thickness t1 of the protrusion portion 510 may vary. in an embodiment, for example, as shown in FIG. 4, the protrusion portion 510 may include a plane (or flat) portion 511 and an inclined portion 512. The plane portion 511 is disposed in the center of the protrusion portion 510 and forms a flat surface. The inclined portion 512 forms an inclined surface having a thickness decreasing as being away from the plane portion 511 from two opposite sides of the plane portion 511. Accordingly, the protrusion portion 510 may have a shape in which a center thereof is convex.

In an alternative embodiment, though not shown, the thickness t1 of the protrusion portion 510 may continuously vary. In such an embodiment, the thickness t1 may continuously reduce toward the outer side from the center of the protrusion portion 510. Accordingly, a cross-sectional shape of the protrusion portion 510 in a front view may be, for example, a triangle having round vertexes, or a semi-circular shape. However, the embodiment is not limited thereto and alternatively, the cross-section of the protrusion portion 510 may be a quadrangular shape or an elliptical shape within the scope of the present disclosure.

In an embodiment, the reinforcement part 500 may be an organic layer. In an embodiment, the reinforcement part 500 may include a polymer-based material. The polymer-based material may include at least one selected from an acryl-based resin, an epoxy-based resin, polyimide, and polyethylene. In an embodiment, the reinforcement part 500 may include acrylate. The reinforcement part 500 may be coated by a spray coater.

In an embodiment, the reinforcement part 500 may include a transparent material. Accordingly, the reinforcement part 500 may not influence the visibility of the display panel DP. However, the embodiment is not limited thereto and alternatively, at least a portion of the reinforcement part 500 may include an opaque material. Even in an embodiment where at least a portion of the reinforcement part 500 includes an opaque material, the reinforcement part 500 is arranged in only the peripheral area PA, such that the reinforcement part 500 may not influence the visibility of the display panel DP.

Referring to FIG. 5, the display panel DP of FIG. 4 may be out-folded with respect to the folding axis FAX. In a state where the display panel DP is out-folded, as the thickness of the reinforcement part 500 increases, tensile stress applied to the display panel DP, particularly, the thin-film encapsulation layer TFE and the layers under the thin-film encapsulation layer TFE, is reduced.

While the display panel DP is out-folded, tensile stress may be concentrated on regions of two opposite sides adjacent to the folding axis FAX as shown in FIG. 5. The protrusion portions 510 may be arranged in the regions of the two opposite sides adjacent to the folding axis FAX in the display panel DP. That is, the reinforcement part 500 may be formed thick at the positions corresponding to the two opposite sides of the folding axis FAX on which the tensile force is concentrated, and thus, may reduce tensile stress.

Referring to FIG. 6, the display panel DP of FIG. 4 may be in-folded with respect to the folding axis FAX. In a state where the display panel DP is in-folded, as the thickness of the reinforcement part 500 decreases, tensile stress applied to the thin-film encapsulation layer TFE and the layers under the thin-film encapsulation layer TFE is reduced.

While the display panel DP is in-folded, tensile stress may be concentrated on a region overlapping the folding axis FAX as shown in FIG. 6. The indented portion 520 may be arranged in the region of the display panel DP that overlaps the folding axis FAX and disposed between the protrusion portions 510. That is, the reinforcement part 500 may be formed thin at the positions overlapping the folding axis FAX on which the tensile force is concentrated, and thus, may reduce tensile stress.

As described above, in an embodiment of the display panel DP, tensile force applied to the display panel DP may be reduced in both states where the display panel DP is in-folded and/or out-folded.

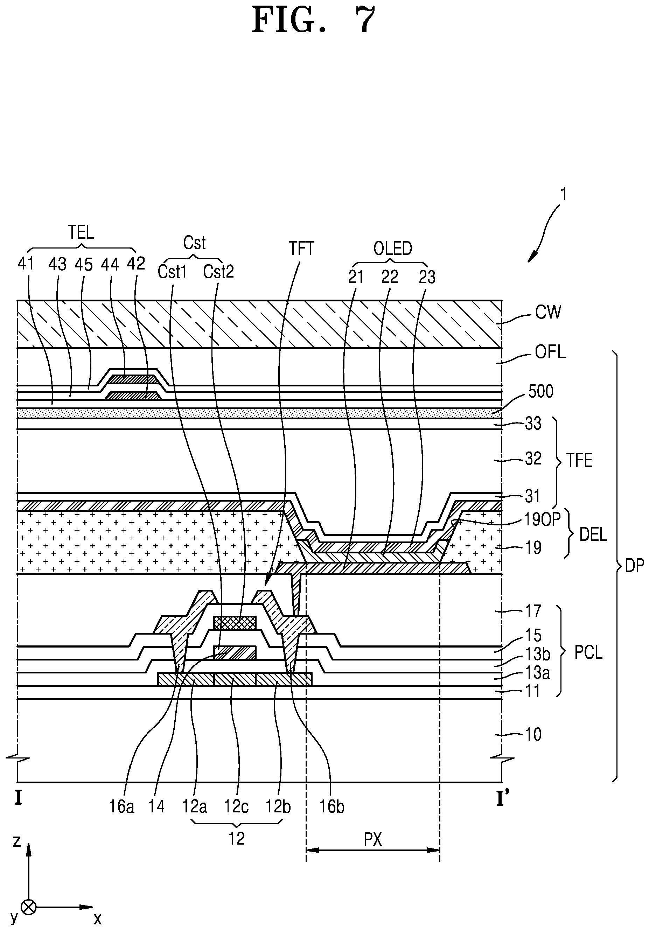

FIG. 7 is a schematic cross-sectional view of the display apparatus 1 according to an alternative embodiment. FIG. 7 is a view similar to FIG. 3 corresponding to the cross-section of the display apparatus 1, taken along line I-I' of FIG. 1. That is, FIG. 7 shows a cross-section of a portion of the display apparatus 1 in the display area DA. The same or like elements shown in FIG. 7 are labeled with the same reference characters as used above to describe the embodiment of the display apparatus shown in FIG. 1, and any repetitive detailed description thereof will hereinafter be omitted or simplified.

Referring to FIG. 7, the reinforcement part 500 may be disposed between the thin-film encapsulation layer TFE and the touch sensor layer TEL in the display area DA. In an embodiment, the reinforcement part 500 may be arranged in the display area DA entirely. In such an embodiment, the reinforcement part 500 may be arranged in the peripheral area PA as shown in FIG. 4. That is, the reinforcement part 500 may be arranged in the display area DA and the peripheral area PA and integrally formed with each other as a single unitary and indivisible body.

In such an embodiment, the thickness of the reinforcement part 500 in the display area DA may be equal to the thickness t3 (see FIG. 4) of the reinforcement part in the region other than the folded area FA in the peripheral area PA. In such an embodiment, the reinforcement part 500 may be formed to have a same thickness t3 in the display area DA and the peripheral area PA, and the protrusion portion 510 (see FIG. 4) and the indented portion 520 (see FIG. 4) may be formed in only the peripheral area PA.

In an embodiment, the reinforcement part 500 may include a transparent material. Accordingly, the reinforcement part 500 may not influence the visibility of the display panel DP. In such an embodiment, the reinforcement part 500 arranged in the display area DA may not influence the visibility of the display panel DP.

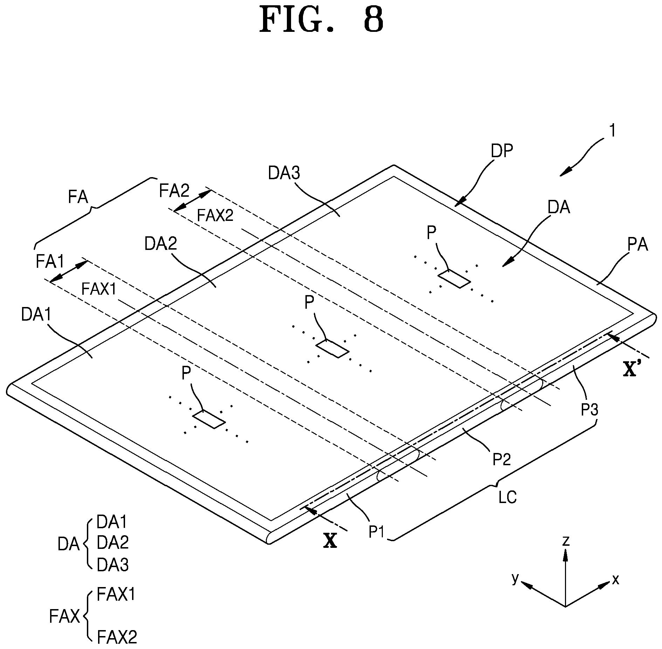

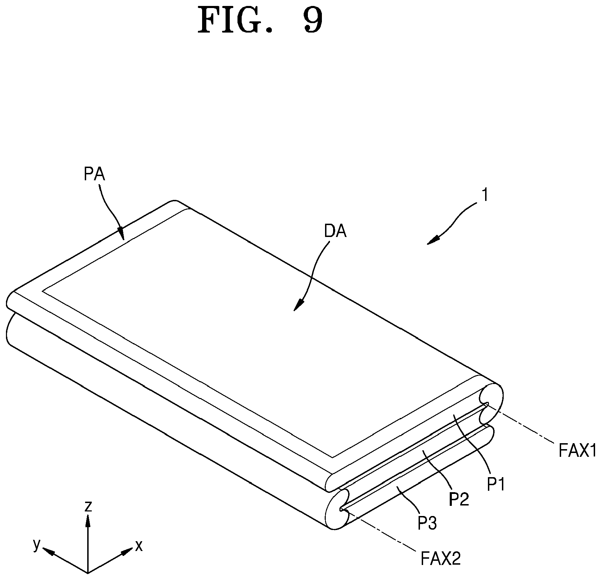

FIGS. 8 and 9 are perspective views of the display apparatus 1 according to an alternative embodiment. Specifically, FIG. 8 shows the display apparatus 1 that is unfolded, and FIG. 9 shows the display apparatus 1 that is folded. Hereinafter, differences of the embodiments shown in FIGS. 8 and 9 from the embodiments of the display apparatus described above will be mainly described.

In an embodiment, the display panel DP may be a flexible display panel which has flexibility and thus is easily bendable, foldable, or rollable. In an embodiment, for example, the display panel DP may include a foldable display panel that is foldable and unfoldable, a curved display panel that has a curved display surface, a bended display panel in which a region except a display surface is bent, a rollable display panel that is rollable and unrollable, and a stretchable display panel that is stretchable.

In an embodiment, the display apparatus 1 may include the lower cover LC, the display panel DP, and the cover window.

The lower cover LC may form the lower appearance of the display apparatus 1. The lower cover LC may include the first part P1 and the second part P2, and a third part P3 supporting the display panel DP. The lower cover LC may be folded around a first folding axis FAX1 defined between the first part P1 and the second part P2. In addition, the lower cover LC may be folded around a second folding axis FAX2 defined between the second part P2 and the third part P3.

The display panel DP may include the display area DA. The first display area DA1 and the second display area DA2 may be defined with the first folding axis FAX1 therebetween. In addition, the second display area DA2 and a third display area DA3 may be defined with the second folding axis FAX2 therebetween.

In an embodiment, the first display area DA1 and the second display area DA2 may be folded not to face each other, that is, out-folded with respect to the first folding axis FAX1. That is, the first part P1 and the second part P2 may be folded to face each other with respect to the first folding axis FAX1. The second display area DA2 and the third display area DA3 may be folded to face each other, that is, in-folded with respect to the second folding axis FAX2. The display apparatus 1 may be folded in a 'Z' shape as shown in FIG. 9.

In an alternative embodiment, the display apparatus 1 may be out-folded with respect to both the first folding axis FAX1 and the second folding axis FAX2. Alternatively, the display apparatus 1 may be in-folded with respect to both the first folding axis FAX1 and the second folding axis FAX2. Hereinafter, for convenience of description, embodiments where the display apparatus 1 is out-folded with respect to the first folding axis FAX1 and in-folded with respect to the second folding axis FAX2 as shown in FIG. 9 are mainly described.

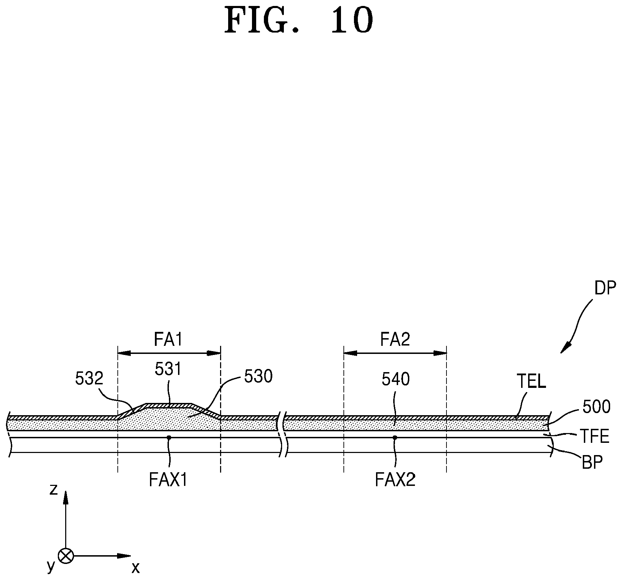

FIG. 10 is a cross-sectional view of a display panel according to an alternative embodiment, taken along line X-X' of FIG. 8. For convenience of description, FIG. 10 schematically shows only the thin-film encapsulation layer TFE, the layers BP under the thin-film encapsulation layer TFE, the reinforcement part 500, and the touch sensor layer TEL, and other elements are the same as and/or similar to those of FIG. 3, and thus, the other elements are not particularly illustrated.

Referring to FIG. 10, the reinforcement part 500 may be disposed on (a +z direction in FIG. 10) of the thin-film encapsulation layer TFE. The reinforcement part 500 may be disposed as a layer on the thin-film encapsulation layer TFE. The touch sensor layer TEL may be disposed on the reinforcement part 500.

In an embodiment, the reinforcement part 500 may be arranged in a peripheral area PA (see FIG. 8). In such an embodiment, the reinforcement part 500 may not be arranged in the display area DA but may be arranged in the peripheral area PA around the display area DA. In an embodiment, the reinforcement part 500 may be arranged on two opposite sides in the lengthwise direction (a y direction in FIG. 8) of the folding axis FAX.

The reinforcement part 500 may include a first reinforcement part 530 and a second reinforcement part 540, where the first reinforcement part 530 is arranged in a first folded area FA1, and the second reinforcement part 540 is arranged in a second folded area FA2. In an embodiment, the first reinforcement part 530 and the second reinforcement part 540 may be connected to each other and provided as one body. That is, the first reinforcement part 530 and the second reinforcement part 540 may be integrally formed with each other as a single layer.

The first reinforcement part 530 may alleviate tensile force applied to the display panel DP in the first folded area FA1 that is out-folded. As shown in FIG. 10, the first reinforcement part 530 may include a plane portion 531 and an inclined portion 532, wherein the plane portion 531 is disposed in the center of the first reinforcement part 530 and forms a flat surface, and the inclined portion 532 forms an inclined portion having a thickness decreasing as being away from the plane portion 531 from two opposite sides of the plane portion 531. Accordingly, the first reinforcement part 530 may have a shape in which a center thereof is convex. In such an embodiment, two opposite sides of the first reinforcement part 530 may be symmetric with respect to the first folding axis FAX1.

In an alternative embodiment, though not shown, the thickness of the first reinforcement part 530 may continuously vary. In such an embodiment, the thickness of the first reinforcement part 530 may continuously reduce toward the outer side from the center of the first reinforcement part 530. Accordingly, a cross-sectional shape of the first reinforcement part 530 in a front view may be, for example, a triangle having round vertexes, or a semi-circular shape. However, the embodiment is not limited thereto and alternatively, the cross-section of the first reinforcement part 530 may be a quadrangular shape or an elliptical shape within the scope of the present disclosure.

The second reinforcement part 540 may alleviate tensile force applied to the display panel DP in the second folded area FA2 that is in-folded. The thickness of the second reinforcement part 540 may be less than the thickness of the first reinforcement part 530. In an embodiment, the thickness of the second reinforcement part 540 may be equal to the thickness in the region other than the folded area FA. In an alternative embodiment, the thickness of the second reinforcement part 540 may be less than the thickness in the region other than the folded area FA. Hereinafter, for convenience of description, embodiments where the thickness of the second reinforcement part 540 is equal to the thickness in the region other than the folded area FA are mainly described.

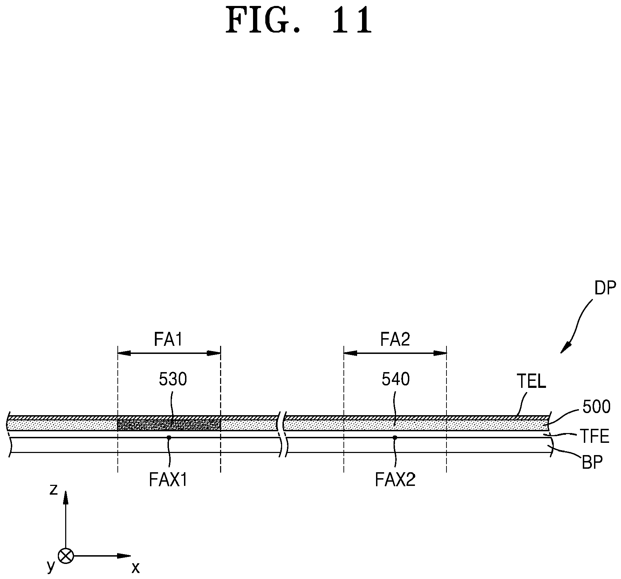

FIG. 11 is a cross-sectional view of a display panel according to an alternative embodiment, taken along line X-X' of FIG. 8. Hereinafter, differences from the above-described embodiment are mainly described.

Referring to FIG. 11, the first reinforcement part 530 and the second reinforcement part 540 may include different materials from each other. In an embodiment, a modulus of the first reinforcement part 530 may be greater than a modulus of the second reinforcement part 540. Accordingly, in the first folded area FA1 that is out-folded, the same effect as that the thickness of the first reinforcement part 530 is thick may be achieved. In such an embodiment, in the second folded area FA2 that is in-folded, the same effect as that the thickness of the first reinforcement part 530 is thin may be achieved.

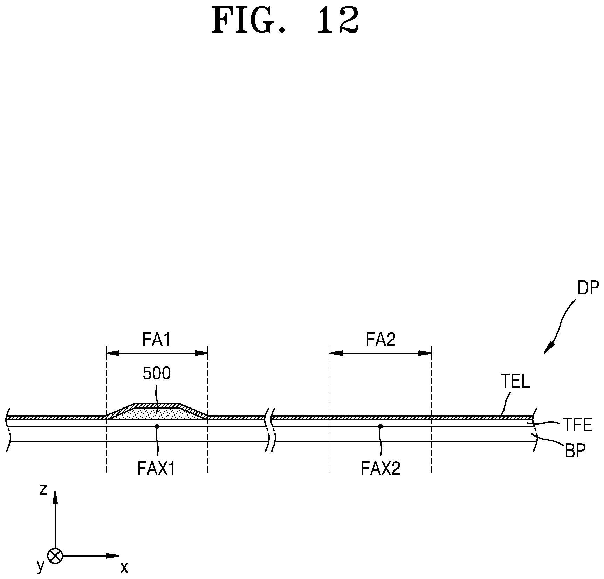

FIG. 12 is a cross-sectional view of a display panel according to an alternative embodiment, taken along line X-X' of FIG. 8. Hereinafter, differences from the above-described embodiment are mainly described.

Referring to FIG. 12, the reinforcement part 500 may be arranged in only the first folded area FA1 that is out-folded. In such an embodiment, the reinforcement part 500 may include only the first reinforcement part 530. The reinforcement part 500 may not be arranged in a region except the first folded area FA1. Accordingly, the touch sensor layer TEL covering the reinforcement part 500 may be disposed on the thin-film encapsulation layer TFE in the region except the first folded area FA1.

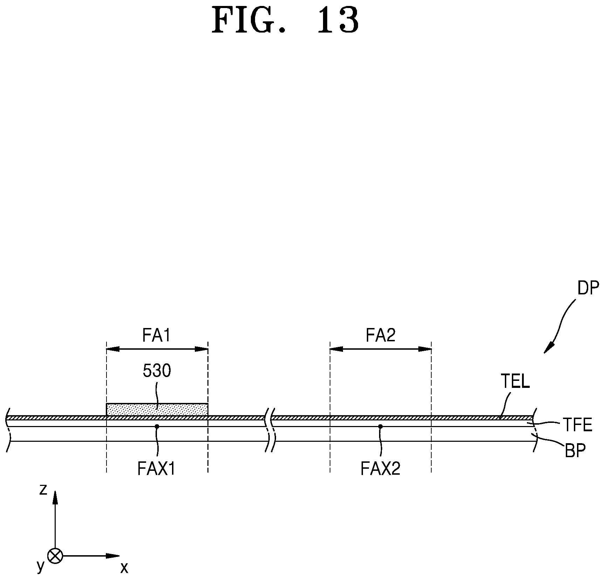

FIG. 13 is a cross-sectional view of a display panel according to an alternative embodiment, taken along line X-X' of FIG. 8. Hereinafter, differences of the embodiment of FIG. 13 from the embodiments described above are mainly described.

Referring to FIG. 13, in an embodiment, the touch sensor layer TEL may be disposed on the thin-film encapsulation layer TFE. The reinforcement part 500 may be disposed on the touch sensor layer TEL. The reinforcement part 500 may be arranged in the first folded area FA1 that is out-folded. In such an embodiment, the reinforcement part 500 may include only the first reinforcement part 530. In such an embodiment, the reinforcement part 500 may not be arranged in the region except the first folded area FA1.

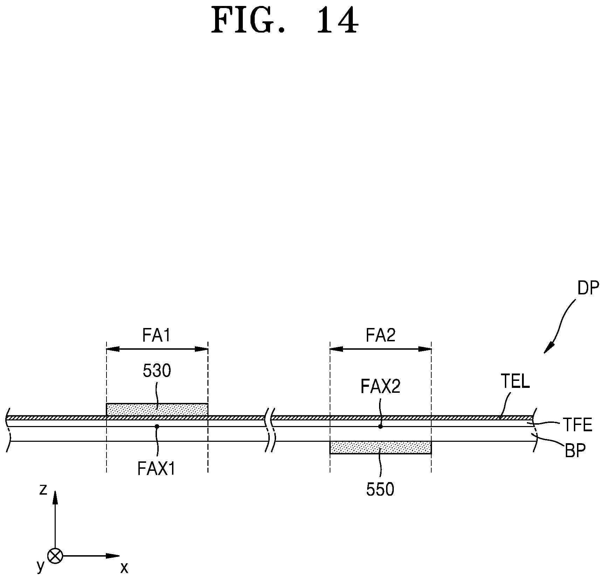

FIG. 14 is a cross-sectional view of a display panel according to an alternative embodiment, taken along line X-X' of FIG. 8. Hereinafter, differences of the embodiment of Fig. 14 from the embodiments described above are mainly described.

Referring to FIG. 14, in an embodiment, the touch sensor layer TEL may be disposed on the thin-film encapsulation layer TFE. The reinforcement part 500, specifically, the first reinforcement part 530 may be disposed on the touch sensor layer TEL, wherein the first reinforcement part 530 is arranged in the first folded area FA1 that is out-folded. In such an embodiment, a backside reinforcement part 550 may be disposed on the backside of a surface of the substrate of the display panel DP on which the first reinforcement part 530 is disposed. The backside reinforcement part 550 may be arranged in the second folded area FA2 that is in-folded. Accordingly, in a state where the display panel DP is in-folded in the second folded area FA2, tensile force applied to the second folded area FA2 through the backside reinforcement part 550 disposed on the backside of the substrate may be alleviated. In such an embodiment, the backside reinforcement part 550 may include a same material as that of the first reinforcement part 530.

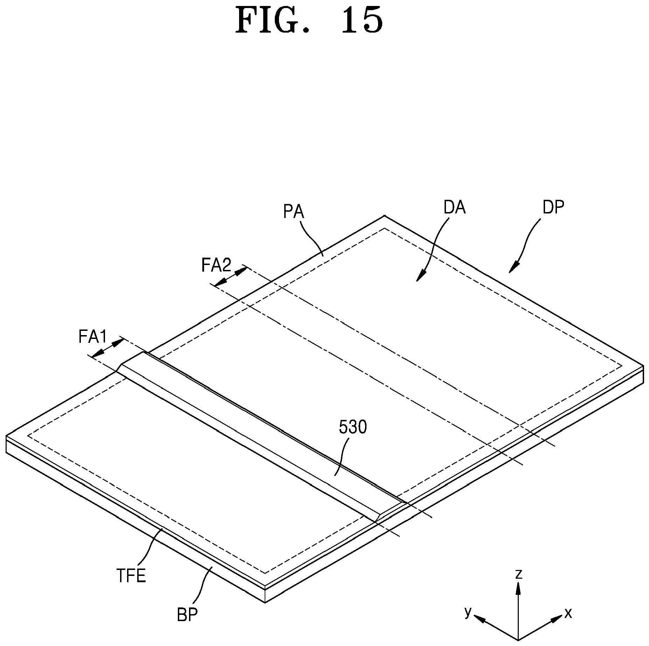

FIG. 15 is a perspective view of a display panel according to an alternative embodiment. For convenience of description, FIG. 15 schematically shows the thin-film encapsulation layer TFE, the layers BP under the thin-film encapsulation layer TFE, and the reinforcement part 500. Hereinafter, differences of the embodiment of FIG. 15 from the embodiments described above are mainly described.

Referring to FIG. 15, in an embodiment, the reinforcement part 500 may be arranged in the display area DA and the peripheral area PA. FIG. 15 shows an embodiment where the reinforcement part 500 has the shape of the reinforcement part 500 of FIG. 12, but the embodiment is not limited thereto. The reinforcement part 500 having another shape of the embodiments described above may be also arranged in the display area DA and the peripheral area PA. The embodiment of FIG. 15 may correspond to the embodiments where the reinforcement part 500 is arranged in only the peripheral area PA.

In such an embodiment, as described above, the reinforcement part 500 may be disposed on the thin-film encapsulation layer TFE, and the touch sensor layer may be disposed to cover the reinforcement part 500. Alternatively, as described above, the touch sensor layer may be disposed on the thin-film encapsulation layer TFE, and the reinforcement part 500 may be disposed on the touch sensor layer. Hereinafter, for convenience of description, embodiments where the reinforcement part 500 is disposed on the thin-film encapsulation layer TFE, and the touch sensor layer is disposed to cover the reinforcement part 500 are mainly described.

The reinforcement part 500 may include the first reinforcement part 530 arranged in the first folded area FA1. The first reinforcement part 530 may extend in the lengthwise direction of the first folding axis FAX1 in the first folded area FA1. That is, the first reinforcement part 530 may extend from the peripheral area PA on one side to the peripheral area PA opposite thereto.

In an embodiment, the first reinforcement part 530 may include a transparent material. Accordingly, the first reinforcement part 530 may not influence the visibility of the display area DA while alleviating stress in the first folded area FA1 that is out-folded.

In an embodiment, the reinforcement part 500 may be arranged in the first folded area FA1 and be patterned not to overlap the opening of the pixel-defining layer of the display element layer. The opening of the pixel-defining layer may define an emission area of light emitted from the emission layer. Accordingly, in such an embodiment where the reinforcement part 500 does not overlap the opening of the pixel-defining layer, the reinforcement part 500 may not influence the visibility of the display area DA.

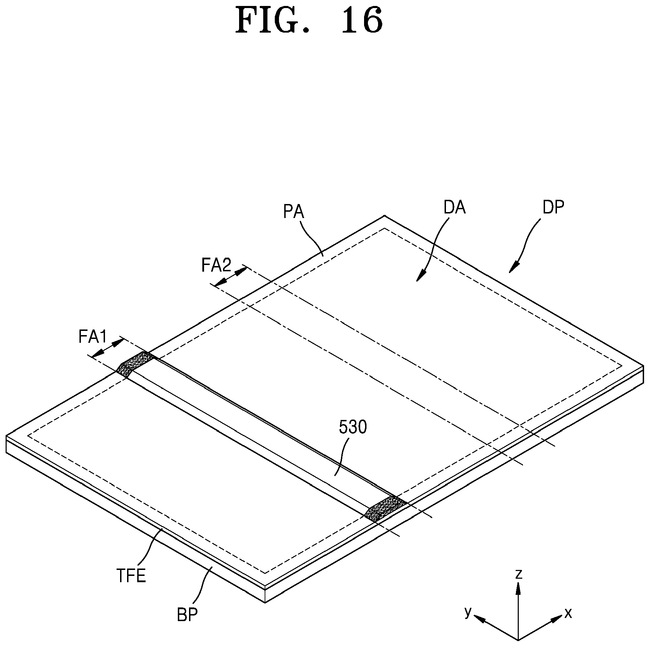

FIG. 16 is a perspective view of a display panel according to an alternative embodiment. For convenience of description, FIG. 16 schematically shows the thin-film encapsulation layer TFE, the layers BP under the thin-film encapsulation layer TFE, and the reinforcement part 500. Hereinafter, differences of the embodiment of FIG. 16 from the embodiments described above are mainly described.

Referring to FIG. 16, in an embodiment, the first reinforcement part 530 may include different materials in the display area DA and the peripheral area PA. In an embodiment, for example, the first reinforcement part 530 may include a transparent material in the display area DA. In such an embodiment, the first reinforcement part 530 may include an opaque material in the peripheral area PA. Accordingly, the first reinforcement part 530 may not influence the visibility of the display area DA.

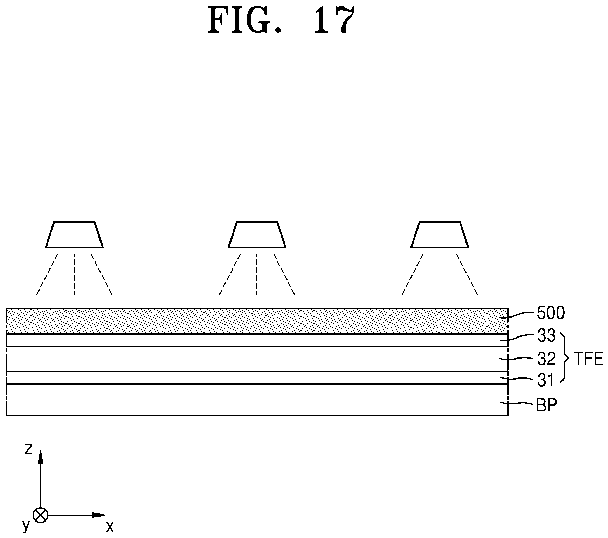

FIGS. 17 to 19 are cross-sectional views showing a method of manufacturing a display apparatus according to an embodiment. The display apparatus to be manufacture in FIGS. 17 to 19 may correspond to the embodiments of the display apparatus described above, but the embodiment is not limited thereto.

Referring to FIG. 17, in an embodiment of a method of manufacturing a display apparatus, the reinforcement part 500 may be provided or disposed on the thin-film encapsulation layer TFE of the display panel DP. In an embodiment, the reinforcement part 500 may include an organic material and be coated on the thin-film encapsulation layer TFE by a spray coater. In an embodiment, the thickness of the reinforcement part 500 may be adjusted by the spray coater. In an embodiment, for example, the reinforcement part 500 may be coated thick in a region of the display panel DP that is out-folded.

Then, the reinforcement part that is coated may be hardened. In an embodiment, the reinforcement part 500 may be hardened by radiating light, for example, an ultraviolet ray or an infrared ray.

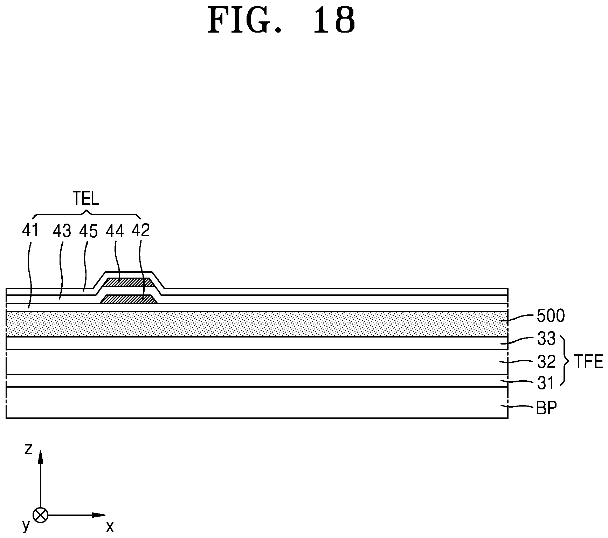

Referring to FIG. 18, the touch sensor layer TEL may be disposed. First, the first touch insulating layer 41 may be formed by one of deposition, coating, printing, and the like.

Next, the first touch conductive pattern 42 may be disposed. The first touch conductive pattern 42 may be formed by forming a first touch conductive layer and patterning the first touch conductive pattern 42 according to a photolithography process.

Then, the second touch insulating layer 43 may be formed by one of deposition, coating, printing, and the like.

Subsequently, the second touch conductive pattern 44 may be disposed on the second touch insulating layer 43. The second touch conductive pattern 44 may be formed by forming a second touch conductive layer and patterning the second touch conductive pattern 44 according to a photolithography process.

Lastly, the third touch insulating layer 45 may be disposed to cover the second touch conductive pattern 44. The third touch insulating layer 45 may be formed by one of deposition, coating, printing, and the like.

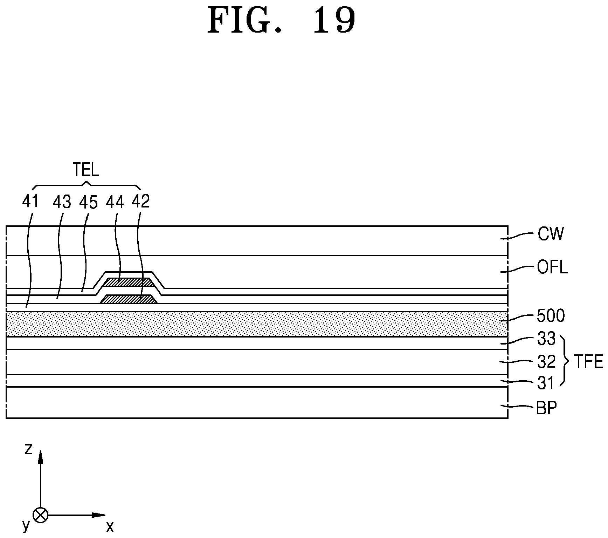

Referring to FIG. 19, the optical functional layer OFL and the cover window CW may be sequentially provided or disposed on the touch sensor layer TEL. After the optical functional layer OFL is stacked, the cover window CW may be attached to the optical functional layer OFL by using an adhesive member. In an embodiment, the adhesive member may be an optically clear adhesive ("OCA"). Alternatively, the adhesive member may be an optically clear resin ("OCR"). The adhesive member may be coated on the optical functional layer OFL, and the cover window CW may be attached to the optical functional layer OFL while the cover window CW faces the adhesive member. In an embodiment, the cover window CW may be disposed on a jig and is attached to the optical functional layer OFL by being pressed toward the optical functional layer OFL.

According to embodiments of the invention, as described herein, the display apparatus may have reinforced durability by suppressing crack occurrence while the display apparatus is folded.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

The present invention can also be defined by reference to the following clauses:
Clause 1. A display apparatus, which is in-folded or out-folded in a folded area thereof, the display apparatus comprising:
   a substrate;
   a plurality of display elements disposed over the substrate;
   an encapsulation layer sealing the plurality of display elements; and
   a reinforcement part disposed on the encapsulation layer and arranged in the folded area.
Clause 2. The display apparatus of clause 1,
   wherein the display apparatus is in-folded or out-folded in a same folded area, and
   wherein a thickness of the reinforcement part varies in the folded area.
Clause 3. The apparatus of clause 2, wherein the reinforcement part includes a protrusion portion disposed on two opposite sides of a folding axis around the folding axis in the folded area.
Clause 4. The display apparatus of clause 3, wherein the protrusion portion includes:
   a plane portion having a constant thickness; and
   an inclined surface portion having a thickness decreasing as being away from the plane portion from two opposite sides of the plane portion.
Clause 5. The display apparatus of clause 3 or clause 4, wherein the protrusion portion is arranged to be symmetric with respect to the folding axis.
Clause 6. The display apparatus of any one of clauses 3 to 5, wherein a thickness of the reinforcement part overlapping the folding axis is less than a thickness of the protrusion portion.
Clause 7. The display apparatus of any one of clauses 1 to 6, wherein the reinforcement part includes a transparent material.
Clause 8. The display apparatus of clause 1, further comprising:
   a display area and a peripheral area surrounding the display area,
   wherein a portion of the reinforcement part in the display area and a portion of the reinforcement part the peripheral area includes different materials from each other.
Clause 9. The display apparatus of any one of clauses 1 to 7, further comprising:
   a display area and a peripheral area surrounding the display area,
   wherein the reinforcement part is arranged in the peripheral area.
Clause 10. The display apparatus of any one of clauses 1 to 9, further comprising:
   a touch sensor layer disposed on the reinforcement part.
Clause 11. The display apparatus of clause 1,
   wherein the folded area includes a first folded area which is out-folded, and a second folded area which is in-folded, and
   wherein the reinforcement part includes a first reinforcement part arranged in the first folded area.
Clause 12. The display apparatus of clause 11, further comprising:
   a touch sensor layer disposed between the first reinforcement part and the encapsulation layer.
Clause 13. The display apparatus of clause 11, wherein the reinforcement part further includes a second reinforcement part disposed on the encapsulation layer and arranged in the second folded area.
Clause 14. The display apparatus of clause 13, wherein the first reinforcement part and the second reinforcement part are connected to each other and integrally formed with each other as a single unitary and indivisible body.
Clause 15. The display apparatus of clause 13 or clause 14, wherein a thickness of the first reinforcement part is greater than a thickness of the second reinforcement part.
Clause 16. The display apparatus of clause 13 or clause 14, wherein the first reinforcement part and the second reinforcement part include different materials from each other.
Clause 17. The display apparatus of clause 11, further comprising:
   a backside reinforcement part disposed on a backside of the substrate in the second folded area.
Clause 18. A display apparatus including a display surface, which is bent in a partial region thereof and displays images, and a non-display surface opposite to the display surface, the display apparatus comprising:
   a substrate; and
   a reinforcement part disposed on the display surface in the partial region of the substrate, wherein the reinforcement part alleviates a tensile force applied to the substrate.
Clause 19. The display apparatus of clause 18, wherein
   the reinforcement part is disposed between an encapsulation layer and a touch sensor layer,
   the encapsulation layer is disposed over the substrate, and
   a touch sensor layer is disposed on the encapsulation layer.
Clause 20. The display apparatus of clause 18 or clause 19, further comprising:
   a display area and a peripheral area surrounding the display area,
   wherein the reinforcement part is arranged in the peripheral area.
Clause 21. The display apparatus of any one of clauses 18 to 20, wherein a thickness of the reinforcement part varies.
Clause 22. A method of manufacturing a display apparatus which is in-folded or out-folded in a folded area thereof, the method comprising:
   providing an encapsulation layer over a substrate over which a plurality of display elements is disposed; and
   coating a reinforcement part on the encapsulation layer in the folded area.
Clause 23. The method of clause 22, wherein the coating the reinforcement part includes coating the reinforcement part in a way such that a thickness of the reinforcement part varies in the folded area.
Clause 24. The method of clause 22 or clause 23, wherein the coating the reinforcement part includes coating the reinforcement part only in a periphery of the substrate in which the plurality of display elements is not arranged.
Clause 25. The method of any one of clauses 22 to 24, further comprising: providing a touch sensor layer on the encapsulation layer to cover the reinforcement part.

## Claims

1. A display apparatus, which is in-foldable or out-foldable in a folded area thereof, the display apparatus comprising:
a substrate;
a plurality of display elements disposed over the substrate;
an encapsulation layer sealing the plurality of display elements; and
a reinforcement part disposed on the encapsulation layer and arranged in the folded area.

2. The display apparatus of claim 1,
wherein the display apparatus is in-folded or out-folded in a same folded area, and
wherein a thickness of the reinforcement part varies in the folded area.

3. The apparatus of claim 2, wherein the reinforcement part includes a protrusion portion disposed on two opposite sides of a folding axis around the folding axis in the folded area.

4. The display apparatus of claim 3, wherein:
(i) the protrusion portion includes:
a plane portion having a constant thickness; and
an inclined surface portion having a thickness decreasing as being away from the plane portion from two opposite sides of the plane portion; and/or
(ii) the protrusion portion is arranged to be symmetric with respect to the folding axis; and/or
(iii) a thickness of the reinforcement part overlapping the folding axis is less than a thickness of the protrusion portion.

5. The display apparatus of any one of claims 1 to 4, wherein the reinforcement part includes a transparent material.

6. The display apparatus of claim 1, further comprising:
a display area and a peripheral area surrounding the display area,
wherein a portion of the reinforcement part in the display area and a portion of the reinforcement part the peripheral area includes different materials from each other.

7. The display apparatus of any one of claims 1 to 5, further comprising:
a display area and a peripheral area surrounding the display area,
wherein the reinforcement part is arranged in the peripheral area.

8. The display apparatus of any one of claims 1 to 7, further comprising:
a touch sensor layer disposed on the reinforcement part.

9. The display apparatus of claim 1,
wherein the folded area includes a first folded area which is out-folded, and a second folded area which is in-folded, and
wherein the reinforcement part includes a first reinforcement part arranged in the first folded area.

10. The display apparatus of claim 9, further comprising:
a touch sensor layer disposed between the first reinforcement part and the encapsulation layer.

11. The display apparatus of claim 9, wherein the reinforcement part further includes a second reinforcement part disposed on the encapsulation layer and arranged in the second folded area, optionally wherein:
the first reinforcement part and the second reinforcement part are connected to each other and integrally formed with each other as a single unitary and indivisible body.

12. The display apparatus of claim 11, wherein:
(i) a thickness of the first reinforcement part is greater than a thickness of the second reinforcement part; and/or
(ii) the first reinforcement part and the second reinforcement part include different materials from each other.

13. The display apparatus of claim 9, further comprising:
a backside reinforcement part disposed on a backside of the substrate in the second folded area.

14. A display apparatus including a display surface, which is bendable in a partial region thereof and displays images, and a non-display surface opposite to the display surface, the display apparatus comprising:
a substrate; and
a reinforcement part disposed on the display surface in the partial region of the substrate, wherein the reinforcement part alleviates a tensile force applied to the substrate.

15. The display apparatus of claim 14, wherein:
(i) the reinforcement part is disposed between an encapsulation layer and a touch sensor layer,
the encapsulation layer is disposed over the substrate, and
a touch sensor layer is disposed on the encapsulation layer; and/or
(ii) the display apparatus further comprises:
a display area and a peripheral area surrounding the display area,
wherein the reinforcement part is arranged in the peripheral area; and/or
(iii) a thickness of the reinforcement part varies.

16. A method of manufacturing a display apparatus which is in-folded or out-folded in a folded area thereof, the method comprising:
providing an encapsulation layer over a substrate over which a plurality of display elements is disposed; and
coating a reinforcement part on the encapsulation layer in the folded area.

17. The method of claim 16, wherein:
(i) the coating the reinforcement part includes coating the reinforcement part in a way such that a thickness of the reinforcement part varies in the folded area; and/or
(ii) the coating the reinforcement part includes coating the reinforcement part only in a periphery of the substrate in which the plurality of display elements is not arranged; and/or
(iii) the method further comprises:
providing a touch sensor layer on the encapsulation layer to cover the reinforcement part.
